# EUROPÄISCHE PATENTANMELDUNG

(11) **EP 4 057 317 A1**
(43) Veröffentlichungstag der Anmeldung: **14.09.2022**
(21) Anmeldenummer: 21161930.9
(22) Anmeldetag: 11.03.2021
(51) Int. Cl.: H01H 59/00, H01H 1/00

(54) **GEKAPSELTES MEMS-SCHALTELEMENT, VORRICHTUNG UND HERSTELLUNGSVERFAHREN**

(71) Anmelder: Siemens Aktiengesellschaft, 80333 München (DE)
(72) Erfinder: Raab, Oliver, 94496 Ortenburg (DE); Schwarz, Markus, 80798 München (DE); Wilke, Hans, 85599 Parsdorf (DE); Zapf, Jörg, 81927 München (DE)

(57) **Zusammenfassung**

Es wird ein mikroelektromechanisches Schaltelement (1) angegeben, umfassend
- ein mehrschichtiges Trägersubstrat (100) mit einer als Trägerschicht dienenden ersten Schicht (110), einer elektrisch isolierenden zweiten Schicht (120) und einer als Halbleiterschicht ausgebildeten dritten Schicht (130),
- ein auslenkbares Biegeelement (135), welches durch einen freigestellten Teilbereich der Halbleiterschicht (130) gebildet ist,
- sowie ein mit dem Trägersubstrat (100) verbundenes flächiges Decksubstrat (200),
- wobei das Trägersubstrat (100) und insbesondere dessen Trägerschicht (110) im Bereich des Biegeelements (135) eine Ausnehmung (150) aufweist, und
- wobei das Decksubstrat (200) im Bereich des Biegeelements (135) ebenfalls eine Ausnehmung (250) und/oder eine umlaufende Abstandsschicht (260) aufweist,
so dass insgesamt ein übergeordneter Hohlraum (350) gebildet ist, in dem das Biegeelement (135) auslenkbar angeordnet ist,
- wobei der übergeordnete Hohlraum (350) derart durch die Trägerschicht (110) und durch das Decksubstrat (200) begrenzt ist, dass er zur äußeren Umgebung hin hermetisch gekapselt ist.

Weiterhin wird eine Vorrichtung mit einem solchen Schaltelement (1) sowie ein Verfahren zur Herstellung eines solchen Schaltelements (1) angegeben.

## Beschreibung

Die vorliegende Erfindung betrifft ein mikroelektromechanisches Schaltelement, das ein mehrschichtiges Trägersubstrat mit einer als Trägerschicht dienenden ersten Schicht, einer elektrisch isolierenden zweiten Schicht und einer als Halbleiterschicht ausgebildeten dritten Schicht umfasst. Das Schaltelement weist ein auslenkbares Biegeelement auf, welches durch einen freigestellten Teilbereich der Halbleiterschicht gebildet ist. Weiterhin betrifft die Erfindung eine Vorrichtung mit einem solchen Schaltelement sowie ein Verfahren zur Herstellung eines solchen Schaltelements.

Aus dem Stand der Technik sind mikroelektromechanische Schaltelemente grundsätzlich bekannt und werden in der Fachwelt auch als MEMS-Schaltelemente bezeichnet. Es handelt sich dabei um mechanische Festkörper-Schaltelemente, welche im Mikrometer- bis Nanometer-Bereich strukturiert sind und elektrostatisch aktuierte Biegeelemente umfassen, so dass sie durch die Änderung einer elektrischen Spannung geschaltet werden können. Häufig wird eine Mehrzahl solcher einzelner MEMS-Schalter zu einem Array angeordnet, insbesondere um eine hinreichend große Stromtragfähigkeit und/oder Spannungsfestigkeit zu erreichen. Solche MEMS-Schalter und darauf aufbauende Schaltvorrichtungen werden beispielsweise in der DE 10 2017 215 236 A1 und der WO 2018 028 947 A1 beschrieben. Gegenstand der DE102017215236A1 ist ein MEMS-Schalter, welcher auf einem Silicon-on-Insulator-Substrat (SOI-Substrat) aufgebaut ist. Mit dieser Fertigungstechnologie können aufgrund der ausgereiften und reproduzierbaren Herstellungsprozesse die vorgegebenen Schaltzeiten besonders präzise eingestellt werden. Dabei wird das Biegeelement mittels subtraktiver Fertigung freigestellt, wobei das SOI-Substrat auf beiden Seiten (oben und unten) prozessiert wird. Die Trägerschicht des SOI-Substrates wird hier von der Rückseite des Substrats aus im Bereich des Biegebalkens vollständig entfernt, so dass eine Auslenkung des Biegebalkens in vertikaler Richtung ermöglicht wird. Auf der Vorderseite des SOI-Substrats (der Seite mit dem Biegeelement) wird typischerweise ein Decksubstrat angeordnet, welches ebenfalls im Bereich des Biegebalkens eine Ausnehmung aufweist. In diesem Bereich des Decksubstrats können eine Steuerelektrode sowie ein oder mehrere Gegenkontakte für den Schaltvorgang angeordnet sein.

Nachteilig bei diesen bekannten SOI-MEMS-Schaltern ist, dass aufgrund der Prozessierung des SOI-Substrats von beiden Seiten relativ leicht eine Schädigung der aktiven SiliziumSchicht während der Herstellung auftreten kann. Ein weiterer Nachteil ist, dass das Biegeelement wegen der offenliegenden Rückseite zunächst nicht vor chemischen und mechanischen Umwelteinflüssen geschützt ist. Es ist zwar grundsätzlich möglich, einen derartigen SOI-MEMS-Schalter in einem übergeordneten Gehäuse einzukapseln. Hierzu werden aber weitere Fertigungsschritte benötigt, und es entsteht ein relativ großes Bauteil, welches in einer übergeordneten Vorrichtung entsprechend viel Bauraum benötigt.

Aus dem Stand der Technik sind auch noch andere Arten von MEMS-Schaltelementen bekannt, beispielsweise mit metallischen Biegebalken. Typischerweise sind jedoch bei dieser Technologie die gewünschten vorbestimmten Schalteigenschaften weniger präzise einstellbar. Auch hier ist für den Schutz vor äußeren Umwelteinflüssen meist die Kapselung mit einem separaten Gehäuse notwendig, was ebenfalls zu vergleichsweise großen Abmessungen führt.

Aufgabe der Erfindung ist es daher, ein Schaltelement zur Verfügung zu stellen, welches die genannten Nachteile überwindet. Insbesondere soll ein Schaltelement zur Verfügung gestellt werden, welches robust gegen äußere Umwelteinflüsse ist und gleichzeitig möglichst kompakt ausgestaltet werden kann. Dabei sollen insbesondere auch die vorgegebenen Schalteigenschaften möglichst präzise eingestellt werden können. Eine weitere Aufgabe ist es, eine Vorrichtung mit einem solchen Schaltelement sowie ein Verfahren zur Herstellung eines solchen Schaltelements anzugeben.

Diese Aufgaben werden durch das in Anspruch 1 beschriebene Schaltelement, die in Anspruch 9 beschriebene Vorrichtung und das in Anspruch 13 beschriebene Herstellungsverfahren gelöst.

Das erfindungsgemäße mikroelektromechanische Schaltelement umfasst ein mehrschichtiges Trägersubstrat mit einer als Trägerschicht dienenden ersten Schicht, einer elektrisch isolierenden zweiten Schicht und einer als Halbleiterschicht ausgebildeten dritten Schicht. Das Schaltelement weist ein Biegeelement auf, welches durch einen freigestellten Teilbereich der Halbleiterschicht (also der dritten Schicht) gebildet ist. Außerdem umfasst das Schaltelement ein mit dem mehrschichtigen Trägersubstrat verbundenes flächiges Decksubstrat. Dabei weist das Trägersubstrat, insbesondere dessen Trägerschicht, im Bereich des Biegeelements eine Ausnehmung auf. Außerdem weist das Decksubstrat im Bereich des Biegeelements ebenfalls entweder eine Ausnehmung und/oder eine um den Bereich des Biegeelements umlaufende Abstandsschicht auf, so dass durch das Zusammenwirken der beiden Ausnehmungen bzw. der einen Ausnehmung und der umlaufenden Abstandsschicht insgesamt ein übergeordneter Hohlraum gebildet ist, in dem das Biegeelement auslenkbar angeordnet ist. Dieser übergeordnete Hohlraum ist derart durch die Trägerschicht und das Decksubstrat begrenzt, dass er zur äußeren Umgebung hin hermetisch gekapselt ist.

Unter einem mikroelektromechanischen Schaltelement soll hier ein Schaltelement verstanden werden, welches mit den Mitteln der Mikrosystemtechnik hergestellt ist. Dabei wird unter dem Begriff Mikrosystemtechnik ganz allgemein die Technik verstanden, die in der Lage ist, mikroskopisch kleine mechanisch wirksame Komponenten herzustellen, die eine Bewegung vollziehen können, beispielsweise Schalter oder Zahnräder. Unter dem Begriff der Mikrosystemtechnik soll hier im weiteren Sinne auch die Nanosystemtechnik eingeschlossen sein, welche entsprechende Strukturen im Submikrometer- bis Nanometerbereich ermöglicht. Allgemein wird hier in der Regel auf Technologien zurückgegriffen, die aus der Halbleiterfertigung grundsätzlich bekannt sind. Solche MEMS-Schalter können auf Glas-, Saphir- und/oder Halbleiter-Substraten (sogenannten Wafern), beispielsweise aus Silizium oder Galliumarsenid gefertigt werden. Die Länge eines MEMS-Schaltelements beträgt hierbei weniger als 1mm, bevorzugt weniger als 500 µm. Hierbei ist das größte konstruktive Element eines einzelnen MEMS-Schaltelements typischerweise das Biegeelement. Dieses Biegeelement ist zweckmäßigerweise länglich geformt, um eine definierte, rückfedernde Auslenkung nach Art einer geraden Blattfeder zu ermöglichen. Das Biegeelement wird daher in den Fachkreisen häufig auch als Biegebalken oder als Schaltzunge bezeichnet. Grundsätzlich sind aber auch andere Formen und Proportionen möglich.

Durch die Herstellung des Biegeelements als freigestellter Teilbereich der (im Schichtsystem obenliegenden) Halbleiterschicht wird erreicht, dass die Schalteigenschaften des Biegeelements, ähnlich wie bei den herkömmlichen SOI-MEMS-Schaltelementen, besonders präzise eingestellt werden können.

Das Biegeelement befindet sich in einem übergeordneten Hohlraum des Bauteils, welches aus zwei flächigen Substraten zusammengesetzt ist, nämlich dem mehrschichtigen Trägersubstrat und dem Decksubstrat. Bei horizontaler Ausrichtung ist dieser Hohlraum nach "oben" (auf der Seite der Halbleiterschicht, also der dritten Schicht des Trägersubstrats) durch das Decksubstrat begrenzt. Durch die außenliegende Fläche des Decksubstrats ist der Hohlraum oben zur Umgebung hin hermetisch gekapselt. In ähnlicher Weise ist der Hohlraum nach "unten" (zur gegenüberliegenden Seite) durch die Trägerschicht zur äußeren Umgebung hin gekapselt. Hierzu ist die Trägerschicht auf ihrer untenliegenden Außenseite insbesondere durchgehend vollflächig ausgebildet und weist zumindest im Bereich des Hohlraums keine durchgehenden Löcher zur äußeren Umgebung hin auf. Außerdem sind das mehrschichtige Trägersubstrat und das Decksubstrat so miteinander verbunden, dass sich umlaufend um den Hohlraum hier ebenfalls eine hermetische Kapselung des Hohlraums nach außen hin ergibt.

Die Bewegung des Biegeelements wird auf der Seite des Trägersubstrats insbesondere dadurch ermöglicht, dass die Trägerschicht im Bereich des Biegeelements eine Ausnehmung aufweist. Wesentlich ist, dass diese Ausnehmung nicht durchgehend ist (also nicht durch die gesamte Trägerschicht durchstößt), sondern nur eine Teilkavität darstellt. Diese Teilkavität ist also eine Art flaches Sackloch und kein nach außen durchgehendes Loch. Mit anderen Worten ist die Trägerschicht im Bereich des Hohlraums nur dünner ausgestaltet als in den umgebenden Bereichen, und sie ist auf der Außenseite trotzdem vollflächig.

Im Unterschied zu den herkömmlichen SOI-MEMS-Schaltelementen wird hier also insgesamt durch die Verbindung von nur zwei Substraten, nämlich dem mehrschichtigen Trägersubstrat und dem Decksubstrat, eine hermetische Kapselung des aktiven Bereichs des Schaltelements erzielt. Ein wesentlicher Vorteil der Erfindung ist, dass für diese hermetische Kapselung kein zusätzliches Gehäuse oder ein anderweitiges (drittes) Substrat benötigt wird, sondern die Kapselung bereits durch zwei, auf Waferebene flächig verbundene Substrate erreicht wird. Hierdurch kann der gesamte Aufbau besonders kompakt realisiert werden.

Die erfindungsgemäße Vorrichtung weist ein erfindungsgemäßes Schaltelement bzw. ein Array von mehreren solchen erfindungsgemäßen Schaltelementen als Teilelement(e) auf. Unabhängig von dem speziellen Anwendungszweck der Vorrichtung ergeben sich ihre Vorteile analog zu den oben beschriebenen Vorteilen des erfindungsgemäßen Schaltelements, insbesondere im Hinblick auf einen Schutz vor Umgebungseinflüssen, eine kompakte Ausführung und/oder eine präzise Einstellung der gewünschten Schalteigenschaften.

Das erfindungsgemäße Verfahren dient zur Herstellung eines erfindungsgemäßen Schaltelements. Dabei wird
a) ein vorgefertigtes mehrschichtiges Trägersubstrat mit einer vorgefertigten Kavität in der Trägerschicht bereitgestellt,
b) aus diesem vorgefertigten Trägersubstrat durch subtraktive Fertigung das Biegeelement freigestellt und
c) in einem Waferbond-Schritt das Decksubstrat mit dem Trägersubstrat dauerhaft verbunden, wodurch der übergeordnete Hohlraum hermetisch gekapselt wird.

Unter dem beschriebenen "Freistellen" des Biegeelements soll verstanden werden, dass zumindest auf einem überwiegenden Teil der Längsausdehnung des Biegeelements die hier angrenzenden Bereiche der Halbleiterschicht entfernt werden.

Bei der vorgefertigten Kavität in der ersten Trägerschicht soll es sich wie oben beschrieben um eine Teilkavität handeln, also um ein nicht zur gegenüberliegenden Seite durchstoßendes Loch. In dem vorgefertigten Trägersubstrat ist insbesondere über dieser vorgefertigten Kavität eine flächig durchgehende Halbleiterschicht angeordnet. Aus dieser flächig durchgehenden Halbleiterschicht wird dann das Biegeelement freigestellt, wobei das mehrschichtige Trägersubstrat insgesamt nur von der Oberseite (der Seite der Halbleiterschicht) und nicht von der Rückseite aus prozessiert werden muss. Aus dem Stand der Technik sind solche vorgefertigten Trägersubstrate mit eingegrabenen Teilkavitäten in der Trägerschicht bekannt. Als spezielle Variante der SOI-Substrate werden diese unter der Bezeichnung C-SOI-Substrate (für Cavity-Silicon-on-Insulator-Substrate) von zahlreichen Herstellern angeboten. Für die Herstellung von Arrays mit einer Vielzahl von MEMS-Schaltelementen können entsprechend auch C-SOI-Substrate mit einer Vielzahl von solchen Kavitäten zum Einsatz kommen, wobei dann insbesondere jeder Kavität mindestens ein freigestelltes Biegeelement zugeordnet ist.

Aufgrund der vorgefertigten Kavität ist das Biegeelement also bereits vor Schritt b) zur Unterseite hin freiliegend, da die Kavität schon einen Teil des für die Auslenkung benötigten übergeordneten Hohlraums bildet. Die hermetische Kapselung des insgesamt gebildeten übergeordneten Hohlraums wird dann in Schritt c) durch die Verbindung des Trägersubstrats mit dem Decksubstrats mittels eines Waferbond-Schritts erreicht. Das erfindungsgemäße Verfahren ermöglicht also eine besonders einfache Herstellung des erfindungsgemäßen Schaltelements, wobei die bereits beschriebenen Vorteile in Bezug auf die Kapselung und die kompakte Ausführung realisiert werden. In optionalen weiteren Schritten (z.B. vor oder nach Schritt b) können auch weitere Elemente mit Techniken der Oberflächenmikromechanik aufgebracht und ggf. strukturiert werden.

Vorteilhafte Ausgestaltungen und Weiterbildungen der Erfindung gehen aus den von den Ansprüchen 1, 9 und 13 abhängigen Ansprüchen sowie der folgenden Beschreibung hervor. Dabei können die beschriebenen Ausgestaltungen des Schaltelements, der Vorrichtung und des Herstellungsverfahrens allgemein vorteilhaft miteinander kombiniert werden.

So kann die Auslenkrichtung des Biegeelements vorteilhaft im Wesentlichen senkrecht zur Schichtebene des mehrschichtigen Trägersubstrats orientiert sein. Mit anderen Worten kann das Biegeelement bei horizontaler Ausrichtung des insgesamt flächig geformten Bauteils nach "oben" und "unten" auslenkbar sein. Eine solche Beweglichkeit aus der Schichtebene des Biegeelements heraus ist mit einem blattfederartig geformten Biegeelement besonders einfach zu realisieren. Die Auslenkung des Biegeelements kann dann also entweder in Richtung der Ausnehmung in der Trägerschicht oder entgegengesetzt, in Richtung der Ausnehmung im Decksubstrat bzw. der durch die umlaufende Abstandsschicht gebildeten Kavität erfolgen.

Allgemein vorteilhaft kann das mehrschichtige Trägersubstrat ein Silicon-on-Insulator-Schichtsystem sein oder ein solches Schichtsystem umfassen. Ein Silicon-on-Insulator (abgekürzt: SOI) Schichtsystem umfasst insbesondere eine Silizium-Isolator-Silizium-Schichtfolge, wobei die Trägerschicht (die erste Schicht des Schichtsystems) durch die untere Siliziumschicht, die zweite Schicht durch den Isolator und die dritte Schicht durch die obere Siliziumschicht gebildet ist. Vorteilhaft kann es sich bei einer der beiden Silizium-Schichten und besonders bevorzugt bei beiden Silizium-Schichten um monokristallines Silizium handeln. Die Isolator-Schicht kann bevorzugt im Wesentlichen durch eine Siliziumdioxid-Schicht (SiO₂) gebildet sein. Sie kann insbesondere als sogenannte vergrabene Oxidschicht (englisch: "buried oxide" oder kurz BOX-Schicht) realisiert sein. Die an sich bekannte SOI-Technologie ermöglicht eine besonders präzise Definition der Schichtdicken und der sonstigen Materialeigenschaften der einzelnen Schichten. Die Halbleiterschicht, aus der das Biegeelement freigestellt wird, ist insbesondere die dünnere der beiden Silizium-Schichten eines typischen SOI-Substrats. Die mechanische Anbindung des Biegeelements an die übrigen Bereiche des Bauteils kann insbesondere über die Isolator-Schicht des SOI-Substrats vermittelt sein. Mit anderen Worten kann das Biegeelement in seinem Fußbereich über die Isolator-schicht an einen mechanisch tragenden Teil des Schaltelements angekoppelt sein. Diese und weitere vorteilhafte Merkmale und Ausführungsvarianten des SOI-Schichtsystems und seiner Prozessierung werden ausführlicher in der DE102017215236A1 beschrieben, welche daher in ihrer Gesamtheit in die Offenbarung der vorliegenden Anmeldung mit einbezogen sein soll. Alternativ zu der oben beschriebenen SOI-Schichtfolge kann die Trägerschicht aber auch beispielsweise durch eine Saphirschicht gebildet sein.

Gemäß einer besonders bevorzugten Ausführungsform eines SOI-MEMS-Schaltelements umfasst die Ausnehmung des Trägersubstrats eine Ausnehmung in der Trägerschicht, und diese ist durch eine vorgefertigte Kavität in dem SOI-Schichtsystem gebildet. Mit anderen Worten ist das Schaltelement auf einem Cavity-SOI-Wafer (abgekürzt: C-SOI-Wafer) aufgebaut. Gemäß einer ersten Alternative dieser vorgefertigten Ausnehmung handelt es sich um eine Teilkavität in der unteren Siliziumschicht, und die vergrabene Oxidschicht ist in diesem Bereich ebenfalls unterbrochen. Gemäß einer zweiten Alternative kann es sich aber auch um eine Teilkavität in der unteren Siliziumschicht handeln, welche im Bodenbereich mit einer entsprechenden Oxidschicht ausgekleidet ist. Beide Arten von C-SOI-Substraten sind geeignet, um mit vergleichsweise geringem Prozessaufwand den benötigten übergeordneten Hohlraum für die Bewegung des Biegeelements bereitzustellen und trotzdem schon innerhalb des Wafer-Schichtsystems eine hermetische Kapselung nach unten hin zu ermöglichen.

Die Verwendung eines C-SOI-Substrates mit einer vorgefertigten Kavität ist jedoch nicht unbedingt erforderlich. So kann alternativ auch erst während des Herstellungsprozesses für das Schaltelement die Teilkavität im Trägersubstrat erzeugt werden. Insbesondere kann sich in diesem Fall die Kavität auf die isolierende zweite Schicht beschränken, und die Trägerschicht kann in voller Dicke erhalten bleiben. Ein solches Loch in der zweiten Schicht (also der vergrabenen Oxidschicht) kann beispielsweise durch Fluorwasserstoff-Ätzen gebildet werden. Die Kavität für die Bewegung des Biegeelement ist dann entsprechend auf die Dicke der Oxidschicht begrenzt und unter Umständen weniger tief. Für die beim Schaltvorgang benötigte vertikale Bewegung kann dies jedoch ebenfalls ausreichend sein, insbesondere wenn die der gegenüberliegende Hohlraum im Bereich des Decksubstrats vergleichsweise tiefer ausgebildet ist.

Allgemein vorteilhaft kann die hermetische Kapselung des übergeordneten Hohlraums in seitlicher Richtung durch eine dauerhafte, fluiddichte, flächige Verbindung zwischen dem mehrschichtigen Trägersubstrat und dem Decksubstrat bewirkt sein. Mit anderen Worten können diese beiden Substrate durch einen sogenannten "Waferbond" verbunden sein. Diese dauerhafte Verbindung kann insbesondere umlaufend um den übergeordneten Hohlraum realisiert sein, so dass der Hohlraum insgesamt nach außen hin hermetisch gekapselt ist. Für einen solchen Waferbond-Schritt sind aus dem Stand der Technik zahlreiche Verfahren bekannt. So kann beispielsweise ein Gold-Silizium-Bond oder ein Germanium-Aluminium-Bond oder eine andere Art von eutektischem Bond zum Einsatz kommen. Alternativ kann die flächige Verbindung auch durch eine Glas-Fritte, durch einen anodischen Bond, durch Thermokompressions-Bonden, durch adhäsives Bonden und/oder durch Fusionsbonden realisiert sein.

Gemäß einer weiteren allgemein vorteilhaften Ausführungsform kann das Decksubstrat funktional als elektrisch isolierendes Decksubstrat ausgebildet sein und insbesondere im Wesentlichen aus Glas oder Silizium gebildet sein. Dies soll so verstanden werden, dass das Glas oder Silizium den Hauptbestandteil des Decksubstrats bildet und zusätzliche Elemente, insbesondere in Form von lokalen Beschichtungen, dabei nicht ausgeschlossen sein sollen. So können insbesondere eine Steuerelektrode sowie zusätzliche Kontaktelemente als weitere Elemente auf der Oberfläche des Decksubstrats aufgebracht sein. Insbesondere können Steuerelektrode und/oder Kontaktelement(e) auf der dem Biegeelement zugewandten Seite des Decksubstrats angeordnet sein. Es können jedoch auch auf der Außenseite des Decksubstrats z.B. Metallisierungen in Form von Leitungselementen und/oder Kontaktelementen und/oder anderen Bauelementen vorhanden sein. Zwischen den beiden Hauptflächen des Decksubstrats können elektrische Durchführungen vorgesehen sein, insbesondere in Form von sogenannten Vias, welche sich senkrecht zur Substratoberfläche durch das Substrat hindurch erstrecken, um Elemente auf Ober- und Unterseite elektrisch zu verbinden. Alternativ kann jedoch auch ein Decksubstrat aus einem leitfähigen Material zum Einsatz kommen, das auf der dem Biegeelement zugewandten Seite mit einer elektrisch isolierenden Schicht beschichtet ist, so dass rein funktional ein elektrisch isolierendes Decksubstrat gebildet ist. Eine solche elektrisch isolierende Schicht kann beispielsweise eine Siliziumdioxid-Schicht oder auch eine Polymerschicht sein.

Allgemein vorteilhaft kann an dem Biegeelement ein Schaltkontakt angeordnet sein. Dieser Schaltkontakt kann beispielsweise durch eine strukturierte Metallisierung auf dem Biegeelement gebildet sein. Optional kann das Biegeelement auch noch weitere funktionale Elemente tragen, es muss also nicht nur aus der genannten Halbleiterschicht bestehen.

Weiterhin kann das Decksubstrat einen ersten Gegenkontakt tragen, welcher abhängig von einer Auslenkung des Biegeelements mit dem Schaltkontakt des Biegeelements kontaktierbar ist. Es kann dann also, wenn das Biegeelement zum Decksubstrat hin ausgelenkt ist und in seinem Endbereich mit diesem in Berührung ist, ein elektrischer Kontakt zwischen dem Schaltkontakt des Biegeelements und einem auf dem Decksubstrat gegenüberliegend angeordneten Gegenkontakt vermittelt werden. Besonders bevorzugt trägt das Decksubstrat sogar ein Paar von Gegenkontakten, welche beide mit dem Schaltkontakt des Biegeelements kontaktiert werden können. Auf diese Weise wird also in der zum Decksubstrat hin ausgelenkten Stellung das Paar von Gegenkontakten elektrisch miteinander verbunden. Diese beiden Gegenkontakte können als sogenannte Lastkontakte eines ersten Last-Schaltkreises ausgebildet sein. So kann mittels des Schaltkontakts der Last-Schaltkreis geschlossen werden, und das Schaltelement ist hier in einer "ON"-Position. Wenn Schaltkontakt und Gegenkontakt(e) nicht verbunden sind, ist das Schaltelement in einer "OFF"-Position.

Gemäß einer weiteren allgemein vorteilhaften Ausführungsform kann das Decksubstrat eine Steuerelektrode aufweisen, mit welcher die Auslenkung des Biegeelements beeinflusst werden kann. Diese Steuerelektrode ist zweckmäßig gegenüber dem Biegeelement platziert, und auf ihr kann im Betrieb die Schaltspannung aufgebracht werden. Eine solche Steuerelektrode wird im Stand der Technik zum Teil auch als Gate-Elektrode bezeichnet. Durch elektrostatische Wechselwirkung zwischen der Steuerelektrode und dem Biegeelement kann das Biegeelement ausgelenkt werden. Z.B. kann es aufgrund von elektrostatischer Anziehung in Richtung des Decksubstrats bewegt werden, so dass es bei dieser Auslenkung zur Ausbildung eines elektrischen Kontakts zwischen einem Kontaktelement des Biegebalkens und einem Kontaktelement des Decksubstrats kommt.

Allgemein und unabhängig von der genauen Ausgestaltung des einzelnen Schaltelements kann die übergeordnete Vorrichtung ein Array von mehreren erfindungsgemäßen Schaltelementen aufweisen. Ein solches Array kann eine Parallelschaltung und/oder eine Serienschaltung von mehreren solchen Schaltelementen sein. Eine Parallelschaltung mehrerer Schaltelemente kann insbesondere dazu dienen, die Stromtragfähigkeit der gesamten Vorrichtung im Vergleich zu einem einzelnen Schaltelement zu erhöhen. Eine Serienschaltung mehrerer Schaltelemente kann insbesondere dazu dienen, die Spannungsfestigkeit im Vergleich zu einem einzelnen Schaltelement zu erhöhen. Auf diese Weise kann die Verwendung eines Arrays dazu beitragen, dass die Vorrichtung die Spezifikationen eines Leistungsschalters einer elektrischen Energieverteilerleitung - insbesondere in einem Niederspannungs- oder Mittelspannungsnetz - erfüllt. Die Anzahl der einzelnen Schaltelemente in dem Array kann dabei an den jeweiligen Spezifikationen ausgerichtet werden. Sie kann beispielsweise bei einigen 10 bis einigen 1000 Schaltelementen liegen und für höhere Leistungsbereiche sogar mehrere hunderttausend betragen.

Gemäß einer weiteren vorteilhaften Ausführungsform der Vorrichtung kann diese neben dem wenigstens einen Schaltelement ein oder mehrere dazu elektrisch in Serie oder parallel geschaltete Halbleiterelemente umfassen. Dabei kann es sich beispielsweise um Transistoren oder andere Halbleiterschaltelemente handeln, wie in der WO2018028947A1 beschrieben. Die zusätzlichen Halbleiterelemente können dabei grundsätzlich auf demselben Substrat wie das Biegeelement gefertigt sein, also monolithisch integriert sein, oder sie können prinzipiell auch auf einem anderen Substrat gefertigt und erst nachträglich mit dem Schaltelement verbunden sein.

Die übergeordnete Vorrichtung kann für den Einsatz in ganz unterschiedlichen Anwendungen ausgelegt sein. So kann sie beispielsweise als Schaltgerät bzw. Schaltschütz, als Umrichter bzw. als Inverter, als Logikschaltung und/oder als logisches Gatter ausgebildet sein. Bei dem Schaltgerät oder Schaltschütz kann es sich insbesondere um ein Gerät für ein Niederspannungs- oder Mittelspannungsnetz handeln. Die Vorrichtung kann allgemein auch eine speicherprogrammierbare Steuerung, insbesondere eine Steuerung für eine industrielle Anlage sein. Erfindungsgemäße Schaltelemente können dabei beispielsweise in einer Eingangsstufe, einer Ausgangsstufe und/oder in einem Sicherheitsrelais einer solchen Anlagensteuerung zum Einsatz kommen.

Allgemein vorteilhaft kann die Vorrichtung als oberflächenmontierbares Bauteil ausgebildet sein. Mit anderen Worten kann es sich um ein SMD- bzw. SMT-Bauelement handeln (SMD für englisch "Surface-mounted device bzw. SMT für englisch "Surface-mounting technology"). Dazu kann die Vorrichtung im Bereich von wenigstens einer seiner Substrat-Außenseiten mit lötfähigen, flächigen SMD-Kontaktstellen versehen sein.

Besonders vorteilhaft ist es im Zusammenhang mit dieser Ausführungsvariante, wenn das Decksubstrat und/oder das Trägersubstrat ein oder mehrere Durchführungen zur elektrischen Kontaktierung des wenigstens einen Schaltelements aufweist. Mit anderen Worten können sogenannte "Vias" vorgesehen sein, welche sich senkrecht zur Substratoberfläche durch das jeweilige Substrat hindurch erstrecken, um Elemente auf Ober- und Unterseite elektrisch zu verbinden. Insbesondere sind solche Vias so ausgestaltet, dass die hermetische Kapselung des übergeordneten Hohlraums durch sie nicht durchbrochen wird. Aus dem Stand der Technik sind unterschiedliche Verfahren bekannt, mit denen solche Vias unter Beibehaltung einer hermetischen Kapselung beispielsweis durch ein Glas- oder Halbleitersubstrats geführt werden können.

Gemäß einer vorteilhaften Weiterbildung des Herstellungsverfahrens kann das Biegeelement durch subtraktive Fertigung aus einem Silicon-on-Insulator-Schichtsystem erhalten werden, wie bereits weiter oben für die entsprechende Ausführungsform des Schaltelements beschrieben. Insbesondere kann das Biegeelement durch Freistellung eines Teils einer Siliziumschicht des SOI-Schichtsystems gebildet sein. Das Herstellungsverfahren kann eine Vielzahl von weiteren optionalen Fertigungsschritten umfassen, welche insbesondere aus der MEMS- und Halbleiter-Prozessierung grundsätzlich bekannt sind. So können beispielsweise zusätzliche Metallisierungsschritte, z.B. in Form einer Beschichtung durch Aufdampfen, Sputtern oder galvanische Abscheidung vorgesehen sein. Die metallischen Schichten für die Elektroden und/oder Kontaktelemente können beispielsweise Gold, Chrom oder Silber oder andere in der Halbleiterfertigung gängige Metalle sowie auch dort eher unübliche Metalle und insbesondere Edelmetalle umfassen. Die (vollständige oder teilweise) Entfernung von einzelnen Schichten kann beispielsweise durch Ätzen und/oder mechanisch/chemisches Polieren und/oder durch einen Lift-off-Prozess erfolgen. Vor allem Ätzprozesse wie chemisches Ätzen mit Flusssäure, reaktives Ionenätzen (RIE für englisch "reactive ion etching" oder DRIE für "deep reactive ion etching") können zur definierten Entfernung von (Teil-)Schichten zum Einsatz kommen. Eine präzise Strukturierung kann dabei durch übliche lithographische Strukturierungsmethoden erreicht werden.

Gemäß einer besonders bevorzugten Ausführungsform des Verfahrens erfolgt die subtraktive Fertigung des Biegeelements in Schritt b) durch ausschließlich einseitige Prozessierung des mehrschichtigen Trägersubstrats. Besonders bevorzugt erfolgt überhaupt nur eine einseitige Prozessierung eines vorgefertigten Trägersubstrats. Mit anderen Worten wird hier eine Prozessierung im Bereich der Rückseite vermieden. Dies bewirkt den Vorteil, dass Schädigungen im Bereich der obenliegenden Halbleiterschicht (also der dritten Schicht des mehrschichtigen Trägersubstrats) vermieden werden können. Diese ausschließlich einseitige Prozessierung wird insbesondere durch die Verwendung von vorgefertigten C-SOI-Substraten ermöglicht, da hiermit ohne rückseitiges Ätzen eine ausreichend große Kavität für die Bewegung des Biegeelements geschaffen werden kann.

Nachfolgend wird die Erfindung anhand einiger bevorzugter Ausführungsbeispiele unter Bezugnahme auf die angehängten Zeichnungen beschrieben, in denen:
- Figur 1: eine schematische Querschnittsdarstellung eines Schaltelements nach dem Stand der Technik zeigt,
- Figur 2: eine schematische Aufsicht eines weiteren bekannten Schaltelements zeigt,
- Figur 3: eine schematische Schnittdarstellung eines herkömmlichen Schaltelements mit einem Gehäuse zeigt,
- Figuren 4 bis 6: mehrere Prozessstadien bei der Herstellung eines erfindungsgemäßen Schaltelements zeigen,
- Figur 7: ein vorgefertigtes Trägersubstrat zur Herstellung eines erfindungsgemäßen Schaltelements zeigt und
- Figur 8: ein Schaltelement nach einem weiteren Beispiel der Erfindung zeigt.

In den Figuren sind gleiche oder funktionsgleiche Elemente mit gleichen Bezugszeichen versehen.

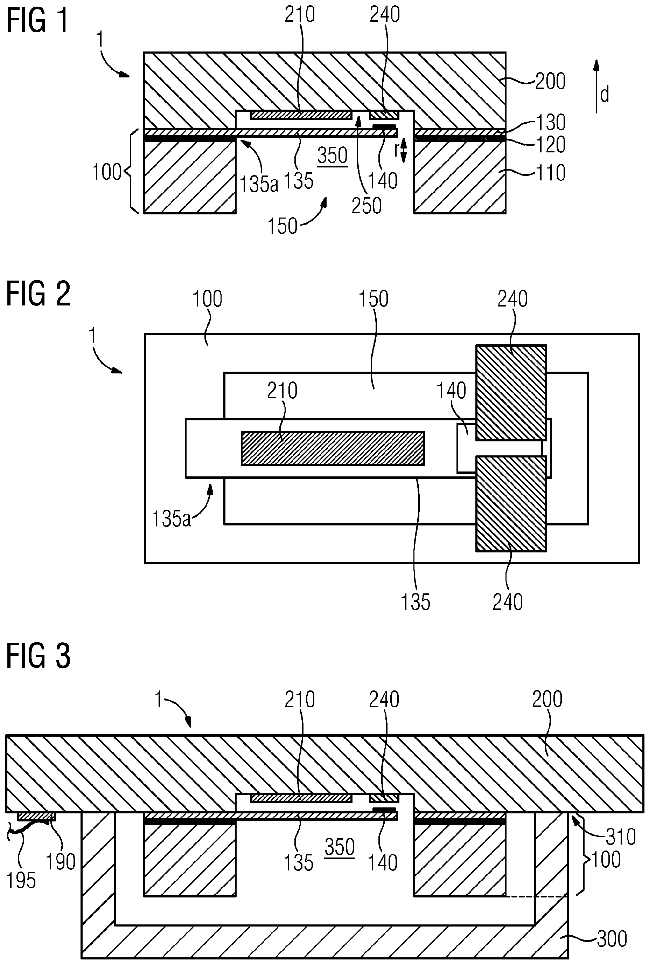

Figur 1 zeigt ein mikroelektromechanisches Schaltelement 1, welches aus dem Stand der Technik bekannt ist. Dieses Schaltelement ist insgesamt ähnlich aufgebaut wie in der DE 10 2017 215 236 A1 beschrieben, es ist hier jedoch der Übersicht halber etwas vereinfacht dargestellt. Das Schaltelement weist ein Silicon-on-Insulator-Schichtsystem 100 auf, welches hier eine erste Siliziumschicht 110, darauf folgend eine vergrabene Oxidschicht 120 und darauf folgend eine weitere Siliziumschicht 130 umfasst. Auf die Schicht 130 kann auch zusätzlich noch eine zweite Oxidschicht als Teil des SOI-Schichtsystems 100 folgen oder zumindest während der Herstellung hier vorgelegen haben. Durch subtraktive Fertigung ist aus der obenliegenden Halbleiterschicht 130 ein Biegeelement 135 definiert und freigestellt worden. Die Herstellung des Biegeelements umfasst dabei die Entfernung der umgebenden Bereiche der Siliziumschicht 130 und die lokale Entfernung der an das Biegeelement 135 angrenzenden Teile der Schichten 110 und 120. So wurde hier ein in der Dickenrichtung d auslenkbares Biegeelement 135 erzeugt, ähnlich wie in der DE 10 2017 215 236 A1 beschrieben. Auch die übrigen Fertigungsschritte können analog zu der DE 10 2017 215 236 A1 durchgeführt werden. Der Fußbereich 135a des Biegeelements, in dem dieses mechanisch mit den übrigen Teilen des SOI-Schichtsystems verbunden ist, ist hier etwas vereinfacht gestaltet bzw. gezeigt. Alternativ zu dieser einfacheren Realisierung kann der Fußbereich 135a aber auch analog zur DE 10 2017 215 236 A1 oder auch der noch nicht veröffentlichten europäischen Patentanmeldung 20182568.4 ausgestaltet sein.

Nach oben hin ist das Bauteil durch ein Decksubstrat 200 abgedeckt, welches beispielsweise aus Glas gebildet sein kann. Dieses Decksubstrat 200 kann beispielsweise durch einen Waferbond-Schritt mit dem SOI-Schichtsystem 100 verbunden worden sein. Im Bereich des Biegebalkens weist das Decksubstrat eine Ausnehmung 250 auf, so dass zusammen mit der Öffnung 150 in den Schichten 110 und 120 ein übergeordneter Hohlraum 350 gebildet wird, in dem das Biegeelement 135 ausgelenkt werden kann. Die Trägerschicht 110 ist dabei im Bereich der Öffnung 150 von der Substratunterseite her vollständig weggeätzt worden, so dass das Biegeelement hier von der unten dargestellten Seite aus frei zugänglich ist.

Um die Auslenkung des Biegeelements zu bewirken, ist auf dem Decksubstrat 200 im Bereich oberhalb des Biegeelements 135 eine Steuerelektrode 210 vorgesehen. Durch eine Spannungsbeaufschlagung der Steuerelektrode 210 kann eine Auslenkung des Biegeelements elektrostatisch aktuiert werden. Wenn das Biegeelement 135 in Richtung d nach oben ausgelenkt wird, kann es in seinem Endbereich so weit in Kontakt mit dem Decksubstrat gebracht werden, dass ein auf dem Biegeelement 135 aufgebrachter Schaltkontakt 140 und ein in der Ausnehmung des Decksubstrats 200 aufgebrachter Gegenkontakt 240 elektrisch in Verbindung treten. Auf diese Weise kann das Schaltelement auf "ON" geschaltet werden, und ein zugehöriger Last-Stromkreis kann mit dem Schaltelement 1 geschlossen werden.

Das gezeigte Schaltelement 1 kann als Teil einer übergeordneten Vorrichtung vorliegen, welche insbesondere ein Array von untereinander ähnlichen Schaltelementen aufweisen kann. Ein solches MEMS-Array kann monolithisch aus demselben SOI-Substrat aufgebaut sein. In diesem Fall ist der in Figur 1 gezeigte Bereich als Ausschnitt aus einem größeren Bauelement zu verstehen, wobei sich die lateralen Schichten noch weiter nach rechts und links (und natürlich auch senkrecht zur Papierebene) erstrecken und in diesen Raumrichtungen noch weitere ähnlich aufgebaute Schaltelemente umfassen können.

Figur 2 zeigt eine schematische Aufsicht eines solchen konventionellen Schaltelements, welches bezüglich seiner Schichtfolge insbesondere ähnlich wie das Schaltelement der Figur 1 aufgebaut sein kann. Die Auslenkungsrichtung r liegt hier jedoch senkrecht zur Zeichnungsebene, und es sind sowohl Element des SOI-Substrats 100 als auch Elemente des Decksubstrats 200 übereinanderliegend eingezeichnet. Die auf dem Decksubstrat 200 angeordneten Metallisierungen der Steuerelektrode 210 und der beiden Gegenkontakte 240 verdecken dabei zum Teil die darunterliegenden Schichten.

Im Fußbereich 135a des Biegeelements ist dieses an die übrigen Schichten des SOI-Schichtsystems 100 angebunden und über die flächige Wafer-Verbindung mit dem Decksubstrat 200 verbunden. Im mittleren Bereich tritt das Biegeelement elektrostatisch mit der darüberliegenden Steuerelektrode 210 auf dem Decksubstrat in Wechselwirkung, insbesondere wenn diese mit einer Schaltspannung beaufschlagt wird. Im Endbereich trägt das Biegeelement einen Schaltkontakt 140. Gegenüberliegend findet sich in diesem Beispiel auf dem Decksubstrat ein Paar von nebeneinanderliegenden Gegenkontakten 240. Bei Auslenkung des Biegeelements werden diese beiden Kontakte 240 mit dem Schaltkontakt 140 des Biegeelements und durch diesen auch miteinander elektrisch verbunden, das Schaltelement befindet sich dann in ON-Stellung. Die in Figur 1 dargestellte Grundstellung mit unausgelenktem Biegeelement entspricht dagegen der OFF-Stellung des Schaltelements.

Figur 3 zeigt ein ähnliches herkömmliches Schaltelement, welches allerdings im Unterschied zum Schaltelement der Figur 1 durch ein Gehäuse hermetisch verkapselt ist, wodurch insbesondere der Bereich des Schaltelements 135 vor äußeren Umwelteinflüssen geschützt ist. Der innere Aufbau ist insgesamt analog zur Figur 1, wobei allerdings das Decksubstrat 200 in seitlicher Richtung größer ist als das SOI-Substrat und dieses entsprechend seitlich überragt. In dieser Randzone ist das Decksubstrat 200 durch eine umlaufende Verbindung 310 mit einem kappenartigen Gehäusedeckel 300 verbunden, welcher beispielsweise als Glasdeckel ausgebildet ist. Die umlaufende Verbindung 310 kann beispielsweise eine hermetisch dichte Lot- oder Schweißverbindung sein. In diesem Beispiel ist der übergeordnete Hohlraum 350, in welchem sich das Biegeelement bewegt, gegen die äußere Umgebung insgesamt hermetisch gekapselt und zwar nach oben hin durch das Decksubstrat 200 und nach unten hin durch den Gehäusedeckel 300. So ist das Schaltelement 1 insgesamt vor einer Schädigung durch äußere Umwelteinflüsse geschützt. Allerdings ist der Aufbau mit den beiden Substraten 100, 200 und dem Gehäusedeckel 300 sowohl in Dickenrichtung als auch lateral wegen des breiten umlaufenden Rands vergleichsweise voluminös. Im Randbereich können neben dem Gehäusedeckel Kontaktstellen 190 für Bonddrähte 195 vorgesehen sein, welche ebenfalls weiteren Platz beanspruchen. Beispielhaft ist hier nur ein solches Bondpad 190 gezeigt. Es kann durch eine hier nicht näher gezeigte Verbindungsleitung mit einer der Elektroden des Schaltelements (z.B. 210, 240) verbunden sein.

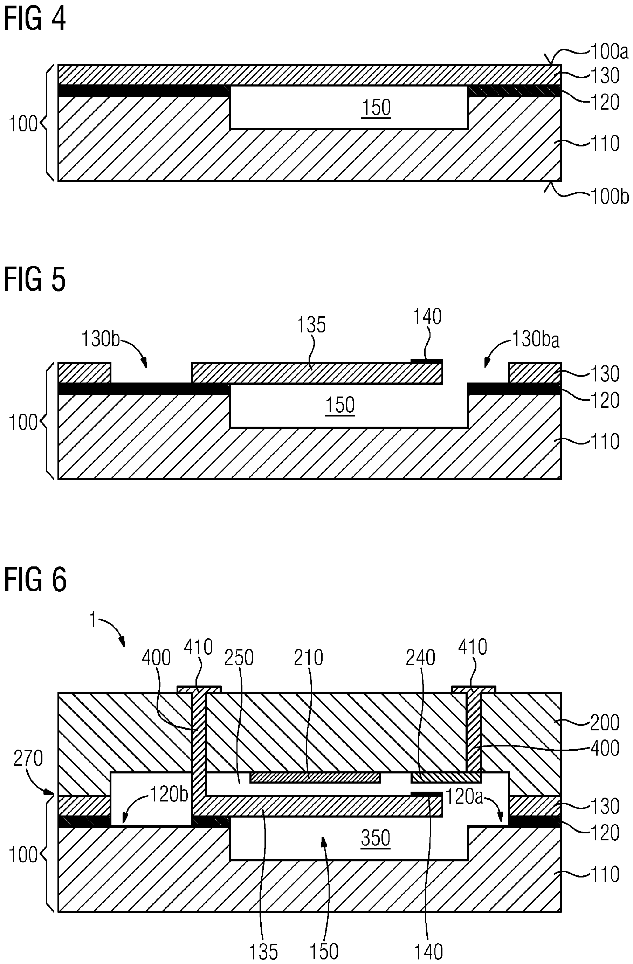

In den Figuren 4 bis 6 sind mehrere Prozessstadien bei der Herstellung eines Schaltelements 1 gemäß der vorliegenden Erfindung gezeigt. Figur 6 zeigt das im Wesentlichen fertig hergestellte Schaltelement 1 bzw. einen lateralen Ausschnitt aus einer entsprechenden Vorrichtung mit mehreren solchen Schaltelementen. In Figur 4 ist ein vorgefertigtes mehrschichtiges Trägersubstrat 100 gezeigt, welches für die Herstellung dieses Schaltelements verwendet wird. Dieses vorgefertigte Trägersubstrat 100 ist auch hier ein SOI-Substrat mit einer Trägerschicht 110 aus Silizium, einer elektrisch isolierenden Schicht 120 aus einem vergrabenen Siliziumoxid und einer obenliegenden dritten Schicht 130, welche ebenfalls eine Siliziumschicht ist. Im Inneren dieses Schichtaufbaus liegt eine vorgefertigte Kavität 150, welche eine Ausnehmung in der Oxidschicht 120 und in einem Teil der Trägerschicht 110 darstellt. Diese Kavität 150 ist aber nur eine Teilkavität, sie ist insbesondere zur Unterseite 100b des Trägersubstrats nicht offen, sondern die Trägerschicht 110 bildet auf der Unterseite 100b trotzdem eine durchgehende flächige Schicht. Auf der Oberseite 100a ist diese Kavität 150 dagegen durch die obenliegende Halbleiterschicht 130 begrenzt. Es ergibt sich also eine geschlossene innenliegende Höhle. Derartige vorgefertigte SOI-Substrate mit eingegrabenen Kavitäten sind aus dem Stand der Technik hinreichend bekannt und werden von zahlreichen Herstellern unter der Bezeichnung C-SOI angeboten. In seitlicher Richtung können auch mehrere solche eingegrabenen Kavitäten nebeneinander vorhanden sein, insbesondere wenn ein Array aus mehreren ähnlichen Schaltelementen hergestellt werden soll. Jede Kavität 150 trägt dann dazu bei, den für die Bewegung des jeweiligen Biegeelements notwendigen übergeordneten Hohlraum zu bilden.

In Figur 5 ist ein weiter fortgeschrittenes Prozessstadium gezeigt, bei dem das Trägersubstrat 100 bereits mehrere Prozessschritte durchlaufen hat. Die Durchführung dieser einzelnen Prozessschritte kann im Detail z.B. analog zu der bereits zitierten DE102017215236A1 ausgestaltet sein. Auch die Materialien und Dicken der einzelnen Schichten und weiteren Elemente können z.B. analog gewählt sein. Wesentlich ist im Zusammenhang mit der vorliegenden Erfindung, dass die Prozessierung vorteilhaft nur von der Oberseite 100a aus erfolgt, dass also keine Lithographie- bzw. Ätzschritte auf der Unterseite 100b durchgeführt werden müssen und das Trägersubstrat 100 bei der Prozessierung entsprechend nur von dieser Unterseite 100b aus gehalten werden muss. Hierdurch wird die Oberseite 100a im Vergleich zu einem doppelseitigen Prozess vorteilhaft vor einer mechanischen Schädigung geschützt.

Beim Prozessstadium der Figur 5 ist im Endbereich des Biegeelements 135 ein metallischer Schaltkontakt 140 strukturiert aufgebracht worden. Außerdem ist die obere Halbleiterschicht 130 in den Bereichen 130a und 130b geöffnet worden. Bei diesen beiden Öffnungen 130a, 130b kann es sich insbesondere in Wirklichkeit um eine einzige, ringförmig um das Biegeelement umlaufende Öffnung in der Schicht 130 handeln. Alternativ kann die Schicht 130 aber auch nur im mittleren Bereich und im Endbereich des Biegeelements entfernt sein (entsprechend Öffnung 130a), und die Öffnung 130b im Fußbereich des Biegeelements kann entfallen, so dass das Biegeelement im Fußbereich ähnlich wie in der Figur 1 auch über die Schicht 130 mit dem restlichen Schichtstapel verbunden bleibt. Für die Ausgestaltung und mechanische Ankopplung des Fußbereichs sind insgesamt unterschiedliche Ausführungen denkbar. Wesentlich ist nur, dass das Biegeelement 135 durch subtraktive Fertigung so weit aus dem Schichtsystem 100 freigestellt wird, dass es senkrecht zur Schichtebene auslenkbar ist. In Richtung der Trägerschicht wird diese Auslenkung durch die bereits im vorgefertigten Schichtsystem 100 vorhandene Kavität 150 ermöglicht.

In Figur 6 ist das im Wesentlichen fertig prozessierte Schaltelement 1 gezeigt. Im Unterschied zur Figur 5 ist hier auch noch die Oxidschicht 120 in den Bereichen 120a und 120b umlaufend um das Biegeelement entfernt worden. Im Anschluss daran wurde das Schichtsystem auf der Substratoberseite 100a durch eine umlaufende flächige Waferbond-Verbindung 270 mit einem Decksubstrat 200 verbunden, ähnlich wie beim herkömmlichen Schaltelement der Figur 1. Das Decksubstrat 200 ist insgesamt ähnlich aufgebaut wie dort und weist auch hier eine Ausnehmung 250 auf, welche zusammen mit der bereits beschriebenen Kavität 150 den übergeordneten Hohlraum 350 für die Bewegung des Biegeelements 135 bildet. Der wesentliche Unterschied zum herkömmlichen Schaltelement der Figur 1 ist, dass der übergeordnete Hohlraum 350 zur Substratunterseite 100b hin nicht offenliegend, sondern abgeschlossen ist. Auf diese Weise wird durch die dauerhafte flächige Verbindung zwischen Trägersubstrat 100 und Decksubstrat 200 eine hermetische Kapselung des Hohlraums 350 erreicht, ohne dass hierfür (wie in Figur 3) noch ein zusätzlicher Gehäusedeckel nötig wäre. Der wesentliche Vorteil dieser erfindungsgemäßen Ausführung ist, dass so auf einfache Weise ein sehr kompaktes Bauteil realisiert werden kann, welches trotzdem robust gegen äußere Umwelteinflüsse ist, da der Bereich des Biegeelements nach außen hin hermetisch gekapselt ist.

Ein weiterer Unterschied im Schaltelement der Figur 6 zum herkömmlichen Bauteil der Figur 3 ist dadurch gegeben, dass die elektrische Kontaktierung hier nicht durch Drahtbonds, sondern durch Vias 400 im Decksubstrats und entsprechende lötfähige Kontaktstellen 410 erfolgt. Es kann sich mit anderen Worten um ein SMD-Bauteil handeln. Dieser zusätzliche Unterschied ist jedoch optional, und es könnte prinzipiell auch eine Kontaktierung über Bonddrähte ähnlich wie in der Figur 3 realisiert werden. Gemäß einer weiteren möglichen Ausführungsform können die Durchführungen 400 alternativ auch durch das Trägersubstrat 100 auf die Unterseite 100b geführt sein oder es könnten entsprechende Vias und Kontaktstellen sowohl auf der Oberseite als auch auf der Unterseite angeordnet sein. Nur beispielhaft ist in Figur 6 ein Via 400 zur Kontierung des Biegeelements (für dessen elektrische Erdung) und ein weiteres Via 400 zur Kontaktierung eines der Gegenkontakte 240 gezeigt. Selbstverständlich können auch weitere Elemente, beispielsweise die Steuerelektrode 210 und der zweite hier nicht sichtbare Gegenkontakt auf entsprechende Weise kontaktiert sein.

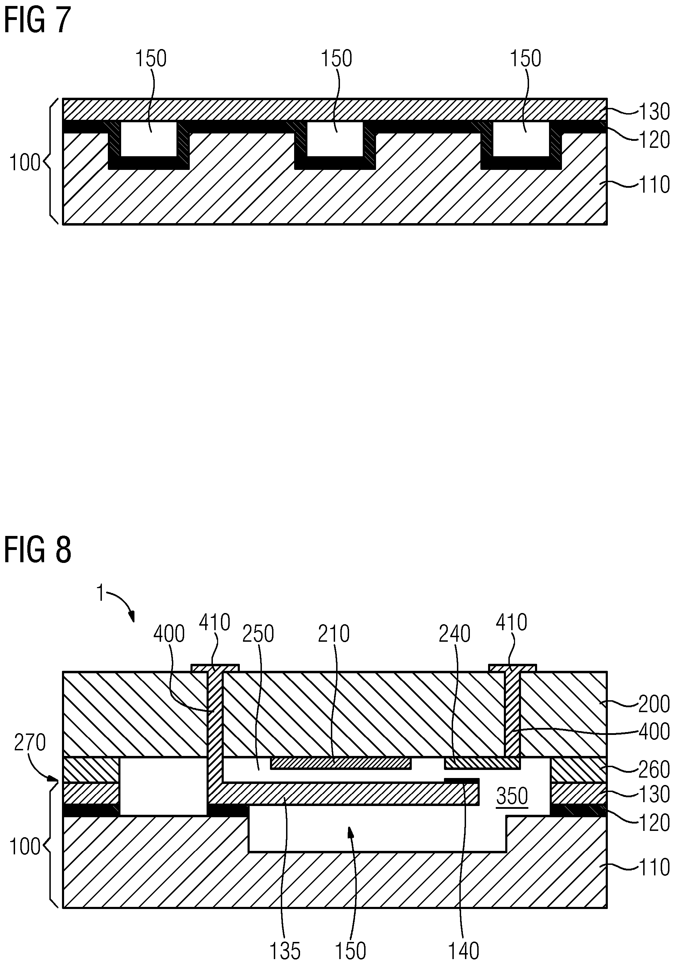

In Figur 7 ist ein weiteres vorgefertigtes Trägersubstrat 100 zur Herstellung eines erfindungsgemäßen Schaltelements gezeigt. Im Unterschied zum Trägersubstrat der Figur 4 weist dieses Trägersubstrat nicht nur eine Kavität, sondern ein Array von mehreren nebeneinanderliegenden vergrabenen Kavitäten 150 auf. Mit anderen Worten kann daraus eine Vorrichtung mit einem Array aus mehreren Schaltelementen hergestellt werden. Ein weiterer Unterschied ist, dass die jeweilige Kavität im Bodenbereich mit einer Oxidschicht ausgekleidet ist. Mit anderen Worten ist die Oxidschicht 120 hier nicht unterbrochen, sondern nur lokal in den Boden der einzelnen Kavitäten 150 verlegt. Auch diese Variante eines C-SOI-Substrats ist bei verschiedenen Herstellern kommerziell erhältlich und kann ansonsten in ähnlicher Weise wie das Substrat der Figur 4 zur Herstellung eines erfindungsgemäßen Schaltelements verwendet werden.

In Figur 8 ist ein Schaltelement 1 nach einem weiteren Beispiel der vorliegenden Erfindung gezeigt. Dieses Schaltelement 1 ist insgesamt ähnlich aufgebaut wie beim Beispiel der Figur 6. Ein Unterschied liegt aber darin, dass das Decksubstrat keine höhlenartige Ausnehmung in seinem Grundmaterial (z.B. im Glas) aufweist, sondern dass der entsprechende Hohlraum hier durch eine um den Bereich des Biegeelements umlaufende Abstandsschicht 260 gebildet wird. Durch den offenen Bereich innerhalb dieser umlaufenden Abstandsschicht 260 ist aber wiederum effektiv eine Ausnehmung 250 des Decksubstrats gebildet, welche zusammen mit der gegenüberliegenden Ausnehmung des Trägersubstrats den übergeordneten Hohlraum 350 für das Biegeelement bildet. Ansonsten ist das Schaltelement der Figur 8 analog zum Beispiel der Figur 6 aufgebaut und kann vorteilhaft auch in analoger Weise mit einem vorgefertigten C-SOI-Substrat hergestellt worden sein.

### Bezugszeichenliste

- 1: MEMS-Schaltelement
- 100: mehrschichtiges Trägersubstrat (SOI-Substrat)
- 100a: Substratoberseite (Vorderseite)
- 100b: Substratunterseite (Rückseite)
- 110: erste Schicht (Trägerschicht)
- 120: zweite Schicht (vergrabenes Oxid)
- 120a: Öffnung der zweiten Schicht
- 120b: Öffnung der zweiten Schicht
- 130: dritte Schicht (Halbleiterschicht)
- 130a: Öffnung der dritten Schicht
- 130b: Öffnung der dritten Schicht
- 135: Biegeelement
- 135a: Fußbereich
- 140: Schaltkontakt
- 150: Ausnehmung (Kavität) bzw. Öffnung
- 190: Kontaktstelle
- 195: Bonddraht
- 200: Decksubstrat
- 210: Steuerelektrode
- 240: Gegenkontakt
- 250: Ausnehmung
- 260: umlaufende Abstandsschicht
- 270: Verbindung (Waferbond)
- 300: Gehäusedeckel
- 310: Verbindung
- 350: übergeordneter Hohlraum
- 400: Durchführung (Via)
- 410: Kontaktstelle
- d: Dickenrichtung
- r: Auslenkungsrichtung

## Patentansprüche

1. Mikroelektromechanisches Schaltelement (1), umfassend
- ein mehrschichtiges Trägersubstrat (100) mit einer als Trägerschicht dienenden ersten Schicht (110), einer elektrisch isolierenden zweiten Schicht (120) und einer als Halbleiterschicht ausgebildeten dritten Schicht (130),
- ein auslenkbares Biegeelement (135), welches durch einen freigestellten Teilbereich der Halbleiterschicht (130) gebildet ist,
- sowie ein mit dem Trägersubstrat (100) verbundenes flächiges Decksubstrat (200),
- wobei das Trägersubstrat (100) und insbesondere dessen Trägerschicht (110) im Bereich des Biegeelements (135) eine Ausnehmung (150) aufweist, und
- wobei das Decksubstrat (200) im Bereich des Biegeelements (135) ebenfalls eine Ausnehmung (250) und/oder eine umlaufende Abstandsschicht (260) aufweist,
so dass insgesamt ein übergeordneter Hohlraum (350) gebildet ist, in dem das Biegeelement (135) auslenkbar angeordnet ist,
- wobei der übergeordnete Hohlraum (350) derart durch die Trägerschicht (110) und durch das Decksubstrat (200) begrenzt ist, dass er zur äußeren Umgebung hin hermetisch gekapselt ist.

2. Schaltelement (1) nach Anspruch 1, bei welchem die Auslenkrichtung (r) des Biegeelements (135) im Wesentlichen senkrecht zur Schichtebene des mehrschichtigen Trägersubstrats (100) orientiert ist.

3. Schaltelement (1) nach einem der Ansprüche 1 oder 2, bei welchem das mehrschichtige Trägersubstrat (100) ein Silicon-on-Insulator-Schichtsystem ist.

4. Schaltelement (1) nach Anspruch 3, bei welchem die Ausnehmung (150) in der Trägerschicht (110) durch eine vorgefertigte Kavität in dem Silicon-on-Insulator-Schichtsystem (100) gebildet ist.

5. Schaltelement (1) nach einem der vorhergehenden Ansprüche, bei welchem die hermetische Kapselung des übergeordneten Hohlraums (350) durch eine dauerhafte, fluiddichte, flächige Verbindung (270) zwischen dem mehrschichtigen Trägersubstrat (100) und dem Decksubstrat (200) bewirkt ist.

6. Schaltelement (1) nach einem der vorhergehenden Ansprüche, bei welchem das Decksubstrat (200) funktional als elektrisch isolierendes Decksubstrat ausgebildet ist und insbesondere im Wesentlichen aus Glas oder Silizium gebildet ist.

7. Schaltelement (1) nach einem der vorhergehenden Ansprüche, bei welchem an dem Biegeelement (135) ein Schaltkontakt (140) angeordnet ist und bei welchem das Decksubstrat (200) wenigstens einen Gegenkontakt (240) trägt, welcher abhängig von einer Auslenkung des Biegeelements (135) mit dem Schaltkontakt (140) des Biegeelements (135) kontaktierbar ist.

8. Schaltelement (1) nach einem der vorhergehenden Ansprüche, bei welchem das Decksubstrat (200) eine Steuerelektrode (210) aufweist, mit welcher die Auslenkung des Biegeelements (135) beeinflusst werden kann.

9. Vorrichtung mit einem mikroelektromechanischen Schaltelement (1) oder einem Array von mehreren mikroelektromechanischen Schaltelementen (1) nach einem der vorhergehenden Ansprüche.

10. Vorrichtung nach Anspruch 9, welche als Schaltvorrichtung, als Umrichter bzw. Inverter, als Logikschaltung und/oder als logisches Gatter ausgebildet ist.

11. Vorrichtung nach einem der Ansprüche 9 oder 10, welches als oberflächenmontierbares Bauelement ausgebildet ist.

12. Vorrichtung nach einem der Ansprüche 9 bis 11, bei welchem das Decksubstrat (200) und/oder das Trägersubstrat (100) ein oder mehrere Durchführungen (400) zur elektrischen Kontaktierung des wenigstens einen Schaltelements (1) aufweist.

13. Verfahren zur Herstellung eines Schaltelements (1) nach einem der Ansprüche 1 bis 9, bei welchem
a) ein vorgefertigtes mehrschichtiges Trägersubstrat (100) mit einer vorgefertigten Kavität (150) in der ersten Trägerschicht (110) eingesetzt wird,
b) aus diesem vorgefertigten Trägersubstrat (100) durch subtraktive Fertigung das Biegeelement (135) freigestellt wird und
c) in einem Waferbond-Schritt das Decksubstrat (200) mit dem Trägersubstrat (100) dauerhaft verbunden wird, wodurch der übergeordnete Hohlraum (350) hermetisch gekapselt wird.

14. Verfahren nach Anspruch 13, bei welchem das mehrschichtige Trägersubstrat (100) ein Silicon-on-Insulator-Schichtsystem ist.

15. Verfahren nach einem der Ansprüche 13 oder 14, bei welchem die subtraktive Fertigung in Schritt b) durch ausschließlich einseitige Prozessierung des mehrschichtigen Trägersubstrats (100) erfolgt.
